(19) Europäisches Patentamt
European Patent Office
Office européen des brevets

(11) **EP 3 889 562 B1**

(12) **EUROPÄISCHE PATENTSCHRIFT**

(45) Veröffentlichungstag und Bekanntmachung des Hinweises auf die Patenterteilung:
**18.09.2024  Patentblatt 2024/38**

(21) Anmeldenummer: **21150224.0**

(22) Anmeldetag: **05.01.2021**

(51) Internationale Patentklassifikation (IPC):
*G01K 7/20* (2006.01)  *G01K 7/24* (2006.01)
*G01R 27/02* (2006.01)  *H03K 17/96* (2006.01)

(52) Gemeinsame Patentklassifikation (CPC):
**H03K 17/96; G01K 7/203**

(54) **ELEKTRISCHES INSTALLATIONSMODUL**

ELECTRIC INSTALLATION DEVICE

MODULE D'INSTALLATION ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.03.2020  DE 102020108673**

(43) Veröffentlichungstag der Anmeldung:
**06.10.2021  Patentblatt 2021/40**

(73) Patentinhaber: **Insta GmbH**
**58509 Lüdenscheid (DE)**

(72) Erfinder: **Hopp, Christian**
**44139 Dortmund (DE)**

(74) Vertreter: **Fobbe, Tobias**
**Insta GmbH**
**Hohe Steinert 10**
**58509 Lüdenscheid (DE)**

(56) Entgegenhaltungen:
**DE-B3- 102019 108 680      DE-U1- 202011 051 925**
**JP-A- S63 316 509      US-A- 3 392 348**
**US-A- 4 844 072**

• **ROBERT WIDLAR: "AN-41", 1 October 1970 (1970-10-01), Retrieved from the Internet <URL:http://www.bitsavers.org/components/national/_appNotes/AN-0041.pdf> [retrieved on 20221216]**

**Beschreibung**

Gegenstand der Erfindung ist ein elektrisches Installationsmodul mit einem elektrische/elektronische Komponenten beinhaltenden Gehäuse, mit einer die elektrischen/elektronischen Komponenten bedienseitig bedeckenden Tragplatte und einer Schaltungsanordnung zum Erfassen des Widerstandes eines auf eine Messgröße empfindlichen Sensorelementes, dessen Widerstandswert sich bei ändernder Messgröße ändert, welches Sensorelement in einen Sensorstromkreis in Reihe mit einem kapazitiven Widerstand eingeschaltet ist.

Bei derartigen gebäudetechnischen Installationsmodulen handelt es sich typischerweise um sogenannte Raumbediengeräte. Diese Raumbediengeräte sind Bedien- und Anzeigegeräte, mit denen bestimmte gebäudetechnische Aktoren, etwa die Beleuchtung, die Jalousien, die Heizung und dergleichen bedient werden können. Zu diesem Zweck kann die Bedienoberfläche zur Betätigung der Aktoren Taster aufweisen. In einer anderen Ausgestaltung werden die Bedienelemente auf einem berührungssensitiven Display angezeigt. Die elektrischen/elektronischen Komponenten eines solchen Installationsmoduls befinden sich in dem Gehäuse desselben. Eingebaut ist in ein solches Installationsmodul mitunter auch ein Temperatursensor. Dieser dient zum Erfassen der Raumtemperatur, um in Abhängigkeit von der Raumtemperatur als gebäudetechnischer Aktor etwa die Heizungsanlage oder auch die Jalousien anzusteuern. Ein solcher Temperatursensor ist als Messwiderstand ausgeführt. Eine von dem aktuellen Widerstandswert auf die Temperatur geschlossen werden kann. Die elektrischen/elektronischen Komponenten und somit auch der Temperatursensor sind in dem Installationsmodul von der Umgebung gekapselt enthalten. Die Kapselung dient in erster Linie zum Schutz des Anwenders vor einem elektrischen Schlag und zur sicheren Montage des Gerätes. Darüber hinaus dient das Gehäuse zum Schutz der elektrischen/elektronischen Komponenten gegenüber elektrostatischer Entladungen durch den Anwender.

Der im Rahmen dieser Ausführung benutzte Begriff "elektrische/elektronische Komponenten" umfasst elektrische und/oder elektronische Bauteile, die Teil eines solchen Raumbediengerätes sein können.

Der Temperatursensor wird in ein solches Raumbediengerät integriert, damit nicht zusätzlich noch individuelle Temperatursensoren in dem Raum zur Temperaturerfassung installiert werden müssen. Hierzu würde auch eine Stromversorgung gehören. Allerdings hat die Implementierung eines Temperatursensors in ein solches Installationsmodul den Nachteil, dass eine Änderung der Raumtemperatur nur verzögert durch den Temperatursensor erfasst werden kann. Der mit einem solchen Temperatursensor gebildete Regelkreis für die Ansteuerung der Heizungsanlage ist daher sehr träge. Dieses ist für die Regelung einer Heizungsanlage ungünstig, da im Zusammenhang mit dem Ausregeln eines SOLL-Wertsprunges das Erreichen der Zieltemperatur durch den in einem solchen Installationsmodul verbauten Temperatursensor erst verzögert erfasst wird, und zwar erst dann, wenn sich das Raumbediengerät an die Temperaturänderung angepasst hat. Dieses führt zu einem an sich unerwünschten Überschwingen oder zu einem äußerst trägen Verhalten bei der Regelung der Heizungsanlage. Zudem ist bei einer solchen Anordnung des Temperatursensors dieser der Abwärme der elektrischen/elektronischen Komponenten ausgesetzt, was zu einer bezüglich der Raumtemperatur verfälschten Temperaturerfassung führt.

Eine Verbesserung dieser vorbekannten Installationsmodule ist aus der DE 10 2019 108 680 B3 bekannt. Bei diesem elektrischen Installationsmodul wird zum Platzieren des Sensors, etwa eines Temperatursensors an oder unmittelbar hinter der Oberfläche einer Abdeckung, keine aufwändige galvanische Trennung von der Netzspannung oder eine eigene galvanisch getrennte Stromversorgung benötigt, um den notwendigen Sicherheitsanforderungen zu genügen. Definiert wird diese durch den Körperstrom, mithin demjenigen Stromfluss, der durch den Körper einer Person fließt, wenn diese eine unter Netzspannung stehende Komponente berührt oder in dessen unmittelbare Nähe gelangt. Ein solcher Körperstromfluss ist nur dann möglich, wenn der Strom durch die Person in die Erde abfließen kann, mithin die Person selbst nicht gegenüber der elektrischen Erde isoliert ist. Dieses wird bei normalen Anwendungen die Regel sein. Erreicht wird die Limitierung des Körperstroms dadurch, dass als Sensorstromkreis ein Wechselstromkreis vorgesehen ist. In die phasenseitige Anschlussleitung des Sensors ist ein kapazitiver Vorwiderstand eingeschaltet. Dieser weist eine so hohe Impedanz auf, dass der durch den Sensor fließende Reststrom ohne zusätzliche Maßnahmen für eine Auswertung der Sensordaten nicht ausreicht. Der Messstrom ist daher so gering, dass selbst im Falle einer Berührung durch eine Person nur ein vernachlässigbarer Körperstrom fließt. Bei dem kapazitiven Vorwiderstand handelt es sich typischerweise um einen Schutzkondensator, etwa der Y-Klasse, insbesondere der Klasse Y1. Die Kapazität des Schutzkondensators ist, um den gewünschten Scheinwiderstand (Impedanz) bei Netzfrequenz zu erhalten, sehr gering. Durch die getroffenen Maßnahmen kann der Sensor unmittelbar auf oder hinter einer Oberfläche, insbesondere einer Bedienoberfläche eines Installationsmoduls angeordnet sein, sodass dieser in unmittelbarem Kontakt mit der Umgebung, aus der er die Messgröße, wie beispielsweise die Temperatur, die Luftfeuchte oder dergleichen erfassen soll, angeordnet werden kann.

Um bei diesem elektrischen Installationsmodul Sensordaten zu erfassen, wird die Sperrwirkung des kapazitiven Vorwiderstandes beeinflusst, und zwar durch eine Änderung der Frequenz. Aus diesem Grunde verfügt das vorbekannte Installationsmodul über einen Frequenzgenerator, der die Frequenz im Sensorstromkreis ändert, wenn Sensordaten erfasst werden sollen.

**EP 3 889 562 B1**

Soll das bezüglich der Messgröße sensitive Sensorelement ausgelesen werden, wird die Frequenz im Sensorwechselstromkreis erhöht und der erfasste Messstrom über eine Auswerteschaltung ausgewertet. Die Größe des erfassten Stroms entspricht sodann einer Messgröße, beispielsweise einem Temperaturwert.

Auch wenn mit einem solchen elektrischen Installationsmodul umgebungsabhängige Messgrößen, wie Temperatur, die Luftfeuchte, der Druck, die Helligkeit oder dergleichen durch Platzieren des Sensors unmittelbar im beziehungsweise am Installationsmodul erfasst werden können, ist das Messergebnis durch Schwankungen in der Netzspannung beeinflusst. Änderungen in der Spannung der Netzspannung sind nicht ungewöhnlich, insbesondere auch deswegen, da die Netzspannung auch für eine Signalübertragung, wie beispielsweise die sogenannten Rundrufbefehle genutzt wird.

US 4 844 072 A offenbart Wärmetherapiesysteme, bei denen eine heiße oder kalte Flüssigkeit durch ein Kissen zirkuliert, das in thermischen Kontakt mit einem Patienten gebracht wird. Damit offenbart US 4 844 072 A kein Installationsmodul. Zudem befindet sich der Temperatursensor in unmittelbarer Nähe des Oszillators, so dass die Abwärme keine genaue, unverfälschte Temperaturmessung ermöglicht.

Gemäß des Links *www.bitsavers.org/components/national/_appNotes/AN-0041.pdf* ist ebenfalls ein elektrisches Installationsmodul zur Sensordatenerfassung bekannt geworden - nicht jedoch zur Temperaturerfassung. Auch wird dort keine Zuordnung einer Frequenz zu einer Messgröße vorgenommen und die diesbezüglichen Ergebnisse in einer Look-Up-Tabelle oder in anderer geeigneter Form in einem der Auswerteeinheit zugeordneten Speicher abgelegt.

Ausgehend von diesem diskutierten Stand der Technik liegt der Erfindung daher die Aufgabe zugrunde, ein elektrisches Installationsmodul der eingangs genannten Art dergestalt weiterzubilden, dass das Messergebnis von Spannungsschwankungen im Wechselstromnetz unabhängig ist.

Gelöst wird diese Aufgabe erfindungsgemäß durch ein elektrisches Installationsmodul gemäß Hauptanspruch 1.

In geschickter Weise macht man sich bei der Schaltungsanordnung dieses Installationsmoduls die Möglichkeiten einer astabilen Kippstufe zunutze, indem die Kapazität an dem kapazitiven Masseanschluss als kapazitiver Widerstand genutzt wird, an welchen kapazitiven Masseanschluss das Sensorelement angeschlossen ist. Damit ist dieser kapazitive Widerstand ein kapazitiver Vorwiderstand für das Sensorelement. Typischerweise ist der kapazitive Vorwiderstand als Schutzkondensator, etwa der Y-Klasse, insbesondere der Y1-Klasse ausgeführt. Durchaus möglich ist auch der Einsatz von Y2-Kondensatoren. Eine solche astabile Kippstufe erzeugt eine Frequenz. Diese ist abhängig von den am Aufbau der astabilen Kippstufe beteiligten Komponenten. Das Sensorelement verfügt über einen gewissen Widerstand, der sich, in Abhängigkeit von der zu erfassenden Messgröße, beispielsweise der Temperatur, ändert. Der Anschluss eines Widerstandes an den kapazitiven Masseanschluss einer solchen astabilen Kippstufe hat Einfluss auf die Ausgangsfrequenz. Ein sich an dieser Position in der Schaltungsanordnung ändernder Widerstandswert führt somit zu unterschiedlichen Ausgangsfrequenzen der astabilen Kippstufe. An den Frequenzausgang der Kippstufe ist eine Auswerteeinheit angeschlossen, mit der die anliegende Frequenz erfasst werden kann. Eine bestimmte Frequenz oder ein bestimmter Frequenzbereich steht für eine bestimmte Messgröße oder einen bestimmten Messgrößenbereich. Eine Zuordnung einer Frequenz oder eines Frequenzbereiches zu einer Messgröße oder einem Messgrößenbereich ist zuvor vorgenommen und die diesbezüglichen Ergebnisse in einer Look-Up-Tabelle oder in anderer geeigneter Form in einem der Auswerteeinheit zugeordneten Speicher abgelegt worden.

Bei einer solchen astabilen Kippstufe ist die Frequenz abhängig von den daran beteiligten Komponenten und dem an den kapazitiven Masseanschluss angeschlossenen Sensorelement, und nicht von der Spannung. Hierin liegt die Unempfindlichkeit dieses elektrischen Installationsmoduls gegenüber Schwankungen in der Versorgungsspannung begründet. Vorteilhaft ist zudem, dass dieses Installationsmodul keinen A/D-Wandler benötigt, wodurch die Kosten im Zusammenhang mit dem Aufbau einer solchen Schaltungsanordnung reduziert, jedoch die Performance und die Genauigkeit verbessert sind.

Gemäß einer erfindungsgemäßen Ausführung einer solchen astabilen Kippstufe verfügt diese über einen Komparator und eine durch Widerstände bereitgestellten Komparatorschaltung. Die Komparatorschaltung umfasst einen Spannungsteiler, von dessen zwischen den Widerständen des Spannungsteilers befindlichen Knotenpunkt eine Teilspannung abgezweigt und an den nicht invertierenden Eingang des Komparators gelegt ist. Ferner dient ein Widerstand zum Verbinden des Knotenpunktes mit dem Ausgang des Komparators. Neben diesem Teilspannungsschaltungszweig verfügt die Komparatorschaltung über einen Schaltungszweig, in den der kapazitive Widerstand integriert ist. Dieser ist an den invertierenden Eingang des Komparators angeschlossen. Auch dieser Schaltungszweig verfügt über einen Widerstand, der den invertierenden Eingang des Komparators mit seinem Ausgang verbindet. Da an diesen Schaltungszweig das Sensorelement angeschlossen ist, kann dieser auch als Sensorstromkreis angesprochen werden. Die Widerstände des Spannungsteilers und derjenige, der den Knotenpunkt des Spannungsteilers mit dem Ausgang des Komparators verbindet, weisen gemäß einem Ausführungsbeispiel jeweils den gleichen Widerstandswert auf. Dieses vereinfacht die Frequenzberechnung. Auch ist der, den invertierenden Eingang mit dem Ausgang des Komparators verbindende Widerstand bekannt, ebenso wie die Kapazität des kapazitiven Widerstandes, an dessen Masseanschluss das Sensorelement angeschlossen ist. Bei einer solchermaßen konzipierten astabilen Kippstufe erfolgt eine Frequenzänderung somit ausschließlich in Abhängigkeit von dem aktuellen Widerstandswert des Sensorelementes. Der Wider-

3

standsbereich des Sensorelementes kann sich beispielsweise zwischen 5 bis 30 kΩ erstrecken. Entsprechend groß ist die Bandbreite der durch ein solches Sensorelement bewirkten Frequenzänderung. Damit ist ein solches, typischerweise als Messwiderstand ausgelegtes Sensorelement gegenüber der zu erfassenden Messgröße, wie etwa der Temperatur, sehr sensitiv. Die Auslegung des kapazitiven Widerstandes als Schutzwiderstand gewährleistet die erforderlichen Sicherheitsanforderungen, was bei vorbekannten Kippstufen dieser Art nicht der Fall ist.

Von Vorteil bei einem solchen Installationsmodul ist auch, dass im Zusammenhang mit der Bereitstellung von unterschiedlichen elektrischen Installationsmodulen, die sich hinsichtlich ihres Sensorelementes unterscheiden, ein und dieselbe Schaltungsanordnung mit der astabilen Kippstufe verwendet werden kann, an die dann, je nach Auslegung des Installationsmoduls, das eine oder das andere Sensorelement an den kapazitiven Masseanschluss angeschlossen wird. In Abhängigkeit von dem daran angeschlossenen Sensorelement beziehungsweise der über dieses zu erfassenden Messgröße werden dann die erforderlichen Daten in dem Speicher, beispielsweise in Form einer Look-Up-Tabelle, abgelegt. Hierdurch ist die Herstellung unterschiedlicher Installationsmodule mit einer darin integrierten Schaltungsanordnung mit unterschiedlichen Messelementen aufgrund des modulartigen Aufbaus kostengünstig herstellbar.

Die Kapazität des kapazitiven Vorwiderstandes als Teil der astabilen Kippschaltung beträgt vorzugsweise weniger als 10 nF, insbesondere weniger als 5 nF. In einem Ausführungsbeispiel beträgt die Kapazität dieses kapazitiven Vorwiderstandes nur 1 nF.

In einer Weiterbildung dieses Installationsmoduls ist vorgesehen, dass an den Masseanschluss des Sensorelementes ein zweiter kapazitiver Widerstand, typischerweise als Schutzkondensator derselben Art und derselben Kapazität wie der kapazitive Vorwiderstand ausgeführt, angeschlossen ist. Der gewünschte Schutz bei einer möglichen Berührung oder bei einem Zunahekommen an das Sensorelement ist dann gegeben, für den Fall, dass versehentlich die Spannungsversorgung falsch gepolt angeschlossen werden sollte.

Als Auswerteeinheit ist gemäß einer Ausgestaltung an den Frequenzausgang der astabilen Kippschaltung ein Mikrocontroller angeschlossen. Über diesen erfolgt auch die Auswertung und damit die Ausgabe der in Abhängigkeit von der erfassten Frequenz ermittelten Messgröße.

Nachfolgend ist die Erfindung anhand eines Ausführungsbeispiels unter Bezugnahme auf die beigefügten Figuren beschrieben. Es zeigen:

Fig. 1: eine perspektivische Ansicht eines elektrischen Installationsmoduls mit einem Temperatursensor zum Erfassen der Raumtemperatur,

Fig. 2: ein Schaltbild zum Betreiben des Temperatursensors des Installationsmoduls der Figur 1 und

Fig. 3: die in Figur 2 gezeigte Schaltungsanordnung gemäß einer Weiterbildung.

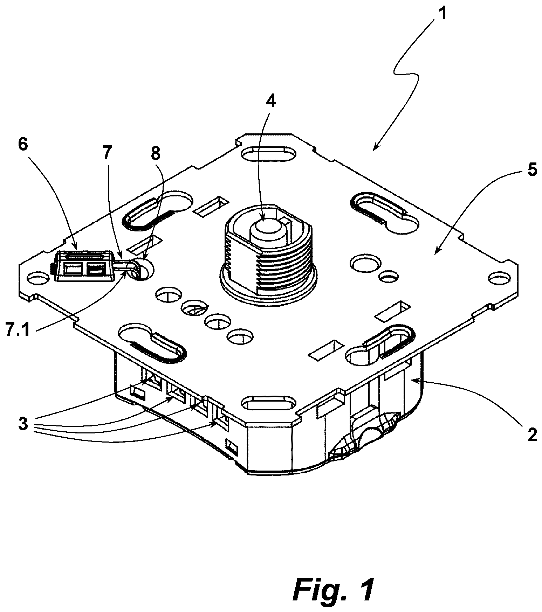

Ein elektrisches Installationsmodul 1 umfasst ein Gehäuse 2, in dem auf einer Leiterplatte elektrische/elektronische Komponenten angeordnet sind. Bei diesen handelt es sich um die notwendigen Komponenten, um mit dem Installationsmodul 1 einen elektrischen Aktor anzusteuern. Bei dem dargestellten Ausführungsbeispiel sitzt auf der Leiterplatte beispielsweise ein Triac. Erkennbar sind in Figur 1 elektrische Anschlussklemmen 3 zum Anschließen des Installationsmoduls an Netzspannung - einerseits - und zum Anschließen des zu betreibenden Aktors - andererseits. Teil der in dem Gehäuse 2 angeordneten elektrischen/elektronischen Komponenten ist ebenfalls ein Stellglied 4, über das manuell Einfluss auf den mit dem Installationsmodul 1 anzusteuernden Aktor genommen werden kann. Das Gehäuse 2 ist bei dem dargestellten Ausführungsbeispiel durch eine Tragplatte 5 bedienseitig verschlossen. Mittels der Tragplatte 5 wird das Installationsmodul 1, das mit seinem Gehäuse 2 typischerweise in eine Unterputzdose hineinreicht, wandseitig befestigt. Zu diesem Zweck ragt die Tragplatte 5 über den äußeren Abschluss des Gehäuses 2 hervor und verfügt über entsprechende Durchbrechungen, durch die Befestiger zum Festlegen des Installationsmoduls an einer Wand hindurchgreifen. Ein Temperatursensor 6, als Messwiderstand ausgeführt, befindet sich als beispielhafter Sensor auf der bedienseitigen Seite der Tragplatte 5 und ist an dieser befestigt. Seine Anschlüsse 7, 7.1 sind durch eine Durchbrechung 8 in der Tragplatte 5 in das Gehäuse 2 geführt und an die in dem Gehäuse 2 befindliche Leiterplatte angeschlossen.

Bei dem dargestellten Ausführungsbeispiel befindet sich der Sensor 6 im Bereich einer unteren Ecke, wenn das Installationsmodul 1 wandseitig montiert ist. Wärme generierende Komponenten innerhalb des Gehäuses 2, wie beispielsweise der angesprochene Triac befinden sich dann oberhalb des Stellgliedes 4. Da Wärme bestrebt ist, nach oben zu steigen, befindet sich der Sensor 6 somit an einer Position, die von Wärme produzierende Komponenten innerhalb des Gehäuses 2 unbeeinflusst, jedenfalls weitestgehend unbeeinflusst ist. Diesem Zweck dient auch bei dem dargestellten Ausführungsbeispiel die Tragplatte 5, durch die die elektrischen/elektronischen Komponenten innerhalb des Gehäuses 2 von der Außenseite derselben getrennt sind.

Eine die Tragplatte 5 verblendende, aus Designrahmen und Frontplatte bestehende Designabdeckung hat an seinem Seitenrand vorzugsweise schlitzartige Öffnungen, sodass Raumluft zwischen dem Designrahmen und der Tragplatte 5 zirkulieren kann. Der Sensor 6 steht dann in unmittelbarem Kontakt mit der umgebenden Raumluft. Es versteht sich, dass die den Designrahmen und die Frontplatte aufweisende Designabdeckung nicht zwei- beziehungsweise mehrteilig ausgeführt werden muss; vielmehr kann diese auch einstückig ausgeführt sein.

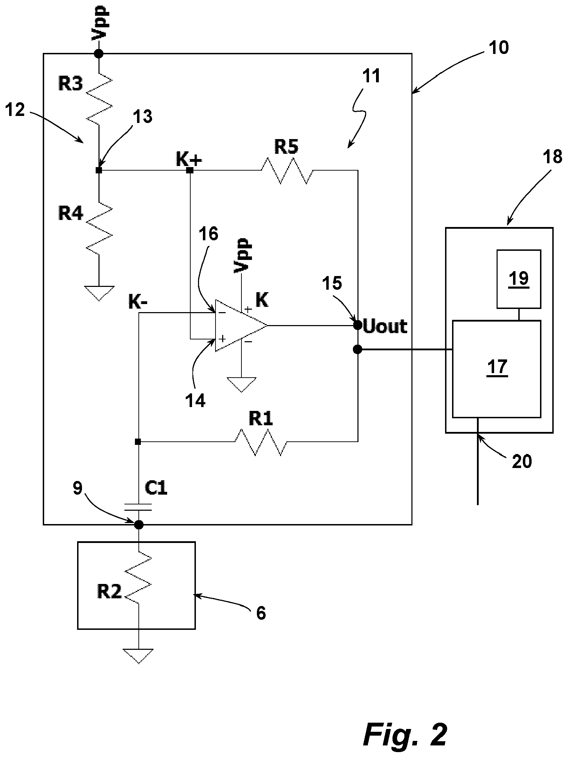

Bei dem Sensor 6 handelt es sich um einen Widerstandssensor, dessen aktueller Widerstand von seiner Temperatur abhängig ist. Der als Widerstand ausgeführte Sensor 6 der in Figur 2 gezeigten Schaltungsanordnung ist an den kapazitiven Masseanschluss 9 einer astabilen Kippstufe 10 angeschlossen. Damit ist der Sensor 6 in Reihe mit dem kapazitiven Widerstand C1 der astabilen Kippstufe 10 geschaltet. Bei dem dargestellten Ausführungsbeispiel handelt es sich bei dem kapazitiven Widerstand C1 um einen Schutzkondensator der Klasse Y1. Anstelle eines Schutzkondensators der Klasse Y1 können auch zwei Schutzkondensatoren der Klasse Y2 eingesetzt werden.

Die astabile Kippstufe 10 umfasst neben dem als Schutzkondensator ausgeführten kapazitiven Widerstand C1 einen Komparator K, der in eine Komparatorschaltung 11 eingebunden ist. Die Komparatorschaltung 11 umfasst einen Spannungsteiler 12 mit zwei Widerständen R3, R4. Der Knotenpunkt 13 zwischen den beiden Widerständen R3, R4 des Spannungsteilers 12 ist an den nicht invertierenden Eingang 14 des Komparators K gelegt. Ein weiterer Widerstand R5 verbindet den Knotenpunkt 13 des Spannungsteilers 12 mit dem Ausgang 15 des Komparators K. Damit entspricht dieser Schaltungsteil einem invertierenden Schmitt-Trigger. Der Komparatorschaltung 11 zugehörig ist zudem ein Sensorstromkreis, der durch den Sensor 6 mit seinem Widerstand R2, dem kapazitiven Widerstand C1 und einen weiteren Widerstand R1 gebildet ist. In diesem Schaltungsast ist der kapazitive Widerstand C1 an den invertierenden Eingang 16 des Komparators K angeschlossen. Angeschlossen ist an diesen Eingang 16 ebenfalls ein Widerstand R1, der diesen Eingang 16 mit dem Ausgang 15 des Komparators K verbindet. Zu ihrer Spannungsversorgung ist die astabile Kippstufe 10 an eine Stromversorgung Vpp (beispielsweise 10 V Wechselspannung) angeschlossen.

Die astabile Kippstufe 10 generiert aufgrund der Auslegung der Komparatorschaltung 11 eine vorgegebene Frequenz, die am Ausgang 15 anliegt. An den Ausgang 15 der astabilen Kippstufe 10 beziehungsweise des Komparators K ist ein Mikrocontroller 17 als Teil einer Auswerteeinheit 18 angeschlossen. Die Auswerteeinheit 18 verfügt des Weiteren über einen elektronischen Speicher 19, in dem, bei dem dargestellten Ausführungsbeispiel, in einer Look-Up-Tabelle bestimmte Daten hinterlegt sind. Da es sich bei dem Sensorelement 6 um einen temperatursensitiven Messwiderstand handelt, sind in der Look-Up-Tabelle frequenzabhängige Temperaturdaten hinterlegt.

Die Auswerteeinheit 18 verfügt über einen Ausgang 20, an dem die mit dem Sensorelement 6 erfasste und durch die Auswertung bereitgestellte Regelgröße - die aktuelle Raumtemperatur bei dem beschriebenen Ausführungsbeispiel - anliegt und in einen Steuer- beziehungsweise Regelkreis, etwa einer Heizungsanlage, eingebracht werden kann.

Bei dem dargestellten Ausführungsbeispiel sind die beiden Widerstände R3, R4 des Spannungsteilers 12 und der Widerstand $R_5$ gleich und weisen einen Widerstand von 1 kΩ auf. Der Widerstandswert des Widerstandes R1 ist ebenfalls bekannt, ebenso wie die Kapazität des kapazitiven Widerstandes C1, die bei dem dargestellten Ausführungsbeispiel 1 nF beträgt. Durch den Anschluss des Sensors 6 mit seinem Widerstand R2 an den kapazitiven Masseanschluss 9 der astabilen Kippstufe 10 wird die ausgangsseitig erfassbare Frequenz in Abhängigkeit von dem aktuellen Widerstand R2 geändert. Der Widerstandswert des Widerstandes R2 des Sensors 6 kann beispielsweise einen Bereich von 5 bis 15 kΩ oder auch 5 bis 30 kΩ betragen. Die am Ausgang 15 erzeugte Frequenz liegt beispielsweise bei einem Widerstandswert des Widerstandes R2 von 10 kΩ bei 30 kHz. Entsprechend der Bandbreite des Widerstandsbereiches des Widerstandes R2 des Sensors 6 ist auch die Bandbreite der am Ausgang 15 erfassbaren Frequenz der astabilen Kippstufe 10. Da der Sensor 6 temperatursensitiv ist, ändert dieser seinen Widerstand R2 in Abhängigkeit von seiner Temperatur.

In dem Speicher 19 sind in einer Look-Up-Tabelle frequenzabhängig Temperaturdaten hinterlegt. Somit ist jeder am Ausgang 15 von dem Mikrocontroller 17 erfassten Frequenz eine bestimmte Temperatur zugeordnet. Diese wird an den Ausgang 20 der Auswerteeinheit 18 gelegt und fließt als Regelgröße in einen Regelkreis ein, mit dem beispielsweise eine Raumtemperierung, beispielsweise die Heizungsanlage, geregelt ist. Da sich der Sensor 6 oberhalb der Tragplatte 5 und somit in unmittelbarer luftdurchströmter Umgebung des zu temperierenden Raumes unterhalb der Designabdeckung befindet, entspricht die am Ausgang 20 der Auswerteeinheit 18 bereitgestellte Regelgröße der tatsächlichen Raumtemperatur, weicht von dieser allenfalls nicht nennenswert ab.

Die Sicherheitsanforderungen an das Installationsmodul 1 in Bezug auf einen Personenschutz sind durch den als Schutzkondensator ausgeführten kapazitiven Widerstand C1 erfüllt.

Die Beschreibung des Installationsmoduls der Figuren 1 und 2 lässt deutlich werden, dass die am Ausgang 15 der astabilen Kippstufe 10 anliegende Frequenz unabhängig von der Stromversorgung Vpp ist. Die am Ausgang 15 anliegende Frequenz lässt sich durch folgende Formel darstellen:

$$f = \frac{1}{-2 \cdot ln\left(\frac{R_1 + R_2}{2R_1 - R_2}\right)(R_1 + R_2) \cdot C_1}$$

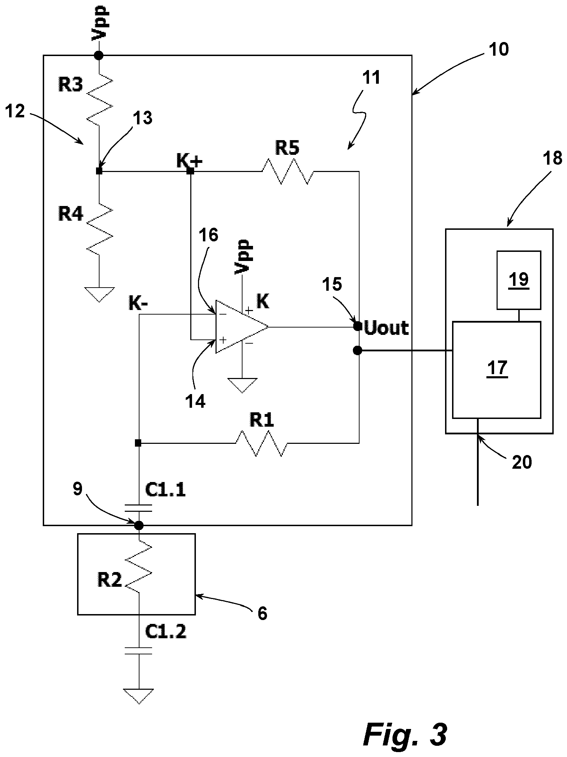

Figur 3 zeigt eine Weiterbildung der astabilen Kippstufe 10 der Figur 2 mit dem an den kapazitiven Masseausgang 9 angeschlossenen Sensor 6 mit seinem Widerstand R2, bei welcher Ausgestaltung in Reihe mit dem Widerstand R2 des Sensors 6 ein zweiter kapazitiver Widerstand C1.2 geschaltet ist. Damit befindet sich der Widerstand R2 zwischen den beiden kapazitiven Widerständen C1.1 und C1.2. Der kapazitive Widerstand C1.2 ist derselbe Schutzwiderstand wie der kapazitive Widerstand C1.1, der dem kapazitiven Widerstand C1 der Gestaltungsanordnung der Figur 2 entspricht. Vorteilhaft bei der Ausgestaltung gemäß Figur 3 ist, dass die notwendigen Sicherheitsanforderungen an einen Personenschutz auch dann gegeben sind, wenn versehentlich die Stromversorgung falschpolig angelegt wird.

Da der kapazitive Widerstand C1, ausgeführt als Schutzkondensator, und ebenfalls diejenigen gemäß C1.1 und C1.2 nur mit einer relativ großen Toleranz gegenüber der Nennkapazität hergestellt werden können (Fehlertoleranzen von bis zu 20 % sind nicht ungewöhnlich), ist es für die exakte Frequenz-Temperaturzuordnung wesentlich, die tatsächliche Kapazität der Schutzkondensatoren C1 bzw. C1.1, C1.2 zu kennen. Dieses kann mit der Schaltungsanordnung ohne weiteres vorgenommen werden, da der jeweilige kapazitive Widerstand, beispielsweise der kapazitive Widerstand C1, Einfluss auf die am Ausgang 15 anliegende Frequenz hat. Um die tatsächliche Kapazität zu ermitteln, wird der Sensor 6 mit seinem Widerstand R2 überbrückt, sodass durch den Widerstand R2 die am Ausgang 15 anliegende Frequenz nicht beeinflusst ist. Da die Einflussnahme der anderen Komponenten - bei dem dargestellten Ausführungsbeispiel der Widerstände R1, R3, R4 und R5 - bekannt sind, kann über die auf diese Weise erzeugte Grundfrequenz der astabilen Kippstufe 10 auf die tatsächliche Kapazität des kapazitiven Widerstandes C1 geschlossen werden. Dieses wird zum Eichen der in der Look-Up-Tabelle hinterlegten Frequenz-Temperatur-Daten genutzt.

Diese Zusammenhänge lassen sich über die nachstehende Formel zum Ausdruck bringen:

$$f = \frac{1}{-2 \cdot \ln(0{,}5) \cdot R_1 \cdot C_1}$$

In der gleichen Weise kann die Kapazität der kapazitiven Widerstände C1.1, C1.2 des in Figur 3 dargestellten Ausführungsbeispiels bestimmt werden.

Die Erfindung ist anhand von Ausführungsbeispielen beschrieben worden. Ohne den Umfang der geltenden Ansprüche zu verlassen, ergeben sich für den Fachmann zahlreiche weitere Möglichkeiten, diese umzusetzen, ohne dass dieses im Rahmen dieser Ausführungen im Einzelnen näher erläutert werden müsste.

**Bezugzeichenliste**

| | |
|---|---|
| 1 | Installationsmodul |
| 2 | Gehäuse |
| 3 | Anschlussklemme |
| 4 | Stellglied |
| 5 | Tragplatte |
| 6 | Sensor |
| 7, 7.1 | Anschluss |
| 8 | Durchbrechung |
| 9 | kapazitiver Masseanschluss |
| 10 | astabile Kippstufe |
| 11 | Komparatorschaltung |
| 12 | Spannungsteiler |
| 13 | Knotenpunkt |
| 14 | nicht invertierender Eingang |
| 15 | Ausgang |
| 16 | invertierender Eingang |
| 17 | Mikrocontroller |
| 18 | Auswerteeinheit |
| 19 | Speicher |
| 20 | Ausgang |
| C1, C1.1, C1.2 | kapazitiver Widerstand |
| K | Komparator |
| R1, R2, R3, R4, R5 | Widerstand |
| Vpp | Stromversorgung |

**Patentansprüche**

1.  Elektrisches Installationsmodul mit einem elektrische/elektronische Komponenten beinhaltenden Gehäuse (2), mit einer die elektrischen/elektronischen Komponenten bedienseitig bedeckenden Tragplatte (5) und einer Schaltungsanordnung zum Erfassen des Widerstandes eines auf eine Messgröße empfindlichen Sensorelementes (6), dessen Widerstandswert sich bei ändernder Messgröße ändert, welches Sensorelement (6) in einen Sensorstromkreis in Reihe mit einem kapazitiven Widerstand (C1, C1.1, C1.2) eingeschaltet ist, **dadurch gekennzeichnet, dass** die astabile Kippstufe (10) einen Komparator (K) mit einer durch Widerstände bereitgestellten Komparatorschaltung (11) umfasst, welche Komparatorschaltung (11) einen Spannungsteiler (12), von dem eine Teilspannung an den nicht invertierenden Eingang (14) des Komparators (K) gelegt ist und unter Zwischenschaltung eines Widerstandes (R5) auch an dem Ausgang (15) des Komparators (K) anliegt, sowie einen kapazitiven Schaltungszweig mit dem an dem invertierenden Eingang (16) des Komparators (K) angeschlossenen kapazitiven Widerstand (C1, C1.1, C1.2) und einen den invertierenden Eingang (16) des Komparators (K) mit seinem Ausgang (15) verbindenden Widerstand (R1) umfasst, wobei der Widerstand (R3) des Spannungsteilers (12) vor dem Knotenpunkt (13), an dem der Teilstrom abgegriffen ist, und der in die Verbindung des Spannungsteilers (12) mit dem Ausgang (15) des Komparators (K) eingeschaltete Widerstand (R5) jeweils denselben Widerstandswert aufweisen.

2.  Installationsmodul nach Anspruch 1, **dadurch gekennzeichnet, dass** der kapazitive Widerstand (C1, C1.1, C1.2) als Schutzkondensator, insbesondere als solcher der Klasse Y1, ausgeführt ist.

3.  Installationsmodul nach einem der Ansprüche 1 bis 2, **dadurch gekennzeichnet, dass** der kapazitive Widerstand (C1, C1.1, C1.2) eine Kapazität von weniger als 10 nF, insbesondere weniger als 5 nF hat.

4.  Installationsmodul nach einem der Ansprüche 1 bis 3, **dadurch gekennzeichnet, dass** das Sensorelement (6) zwischen zwei kapazitiven Widerständen (C1, C1.1, C1.2), insbesondere zwischen zwei Schutzkondensatoren der Klasse Y1 angeordnet ist.

5.  Installationsmodul nach Anspruch 4, **dadurch gekennzeichnet, dass** die Kapazität der beiden kapazitiven Widerstände, zwischen denen das Sensorelement (6) angeordnet ist, gleich ist.

6.  Installationsmodul nach einem der Ansprüche 1 bis 5, **dadurch gekennzeichnet, dass** das Sensorelement (6) ein Messwiderstand ist, der in Bezug auf die zu erfassende Messgröße, wie etwa der Temperatur, der Luftfeuchte oder dergleichen sensitiv ist.

7.  Installationsmodul nach einem der Ansprüche 1 bis 5, **dadurch gekennzeichnet, dass** das Sensorelement (6) auf der Außenseite der Tragplatte (5) des Installationsmoduls (1) sitzt.

**Claims**

1.  Electrical installation module having a housing (2) containing electrical/electronic components, having a supporting plate (5) covering the electrical/electronic components on the operating side and a circuit arrangement for detecting the resistance of a sensor element (6) which is sensitive to a measured variable, the resistance value of which sensor element changes as the measured variable changes, which sensor element (6) is connected in a sensor circuit in series with a capacitive resistor (C1, C1.1, C1. 2), **characterised in that** the astable flip-flop (10) comprises a comparator (K) with a comparator circuit (11) provided by resistors, which comparator circuit (11) comprises a voltage divider (12), of which a partial voltage is applied to the non-inverting input (14) of the comparator (K) and is also applied to the output (15) of the comparator (K) with the interposition of a resistor (R5), and a capacitive circuit branch with the capacitive resistor (C1, C1. 1, C1.2) connected to the inverting input (16) of the comparator (K) and a resistor (R1) connecting the inverting input (16) of the comparator (K) to its output (15), wherein the resistor (R3) of the voltage divider (12) upstream of the node (13) at which the partial current is tapped and the resistor (R5) connected into the connection of the voltage divider (12) to the output (15) of the comparator (K) each have the same resistance value.

2.  Installation module in accordance with Claim 1, **characterised by the fact that** the capacitive resistor (C1, C1.1, C1.2) is designed as protective capacitor, in particular as one of class Y1.

3.  Installation module in accordance with any of Claims 1 to 2, **characterised by the fact that** the capacitve resistor (C1, C1.1, C1.2) has a capacity of less than 10 nF, in particular less than 5 nF.

4. Installation module in accordance with any of Claims 1 to 3, **characterised by the fact that** the sensor element (6) is arranged between two capacitve resistors (C1, C1.1, C1.2), in particular between two protective capacitors of class Y1.

5. Installation module in accordance with Claim 4, **characterised by the fact that** the capacity of the two capacitve resistors, between which the sensor element is arranged, is the same.

6. Installation module in accordance with any of Claims 1 to 5, **characterised by the fact that** the sensor element (6) is a measuring resistor which is sensitive with regard to the variable to be measured, like for instance temperature, humidity or similar.

7. Installation module in accordance with any of Claims 1 to 5, **characterised by the fact that** the sensor element (6) is arranged on the outer side of the supporting plate (5) of the installation module (1).


**Revendications**

1. Module d'installation électrique avec un boîtier (2) contenant des composants électriques/électroniques, avec une plaque de support (5) recouvrant les composants électriques/électroniques du côté de la commande et un circuit pour détecter la résistance d'un élément capteur (6) sensible à une variable mesurée, dont la valeur de résistance varie lorsque la variable mesurée change, lequel élément capteur (6) est monté dans un circuit électrique de capteur en série avec une résistance capacitive (C1, C1.1, C1. 2), **caractérisé en ce que** la bascule instable (10) comprend un comparateur (K) avec un circuit comparateur (11) fourni par des résistances, lequel circuit comparateur (11) comprend un diviseur de tension (12), dont une tension partielle est appliquée à l'entrée non inverseuse (14) du comparateur (K) et est également appliquée à la sortie (15) du comparateur (K) avec interposition d'une résistance (R5), ainsi qu'une branche de circuit capacitif avec la résistance capacitive (C1, C1. 1, C1.2) relié à l'entrée inverseuse (16) du comparateur et une résistance (R1) reliant l'entrée inverseuse (16) du comparateur (K) à sa sortie (15), où la résistance (R3) du diviseur de tension (12) en amont du point nodal (13) sur lequel le courant partiel est prélevé et la résistance (R5) insérée dans la liaison du diviseur de tension (12) avec la sortie (15) du comparateur (K) présentent chacune la même valeur de résistance.

2. Module d'installation électrique selon la revendication 1, **caractérisé en ce que** la résistance capacitive (C1, C1.1, C1.2) est réalisée sous forme de condensateur de protection, en particulier de classe Y1.

3. Module d'installation électrique selon l'une des revendications 1 à 2, **caractérisé en ce que** la résistance capacitive (C1, C1.1, C1.2) a une capacité inférieure à 10 nF, en particulier inférieure à 5 nF.

4. Module d'installation électrique selon l'une des revendications 1 à 3, **caractérisé en ce que** l'élément capteur (6) est disposé entre deux résistances capacitives (C1, C1.1, C1.2), particulièrement entre deux condensateurs de protection de classe Y1.

5. Module d'installation électrique selon la revendication 4, **caractérisé en ce que** la capacité des deux résistances capacitives entre lesquelles l'élément capteur (6) est disposé est égale.

6. Module d'installation électrique selon l'une des revendications 1 à 5,
   **caractérisé en ce que** l'élément capteur (6) est une résistance de mesure qui est sensible à la variable mesurée à détecter, telle que la température, l'humidité de l'air ou similaire.

7. Module d'installation électrique selon l'une des revendications 1 à 5,
   **caractérisé en ce que** l'élément capteur (6) est placé sur le côté extérieur de la plaque de support (5) du module d'installation (1).

**Fig. 1**

**Fig. 2**

*Fig. 3*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102019108680 B3
- US 4844072 A